(19) Europäisches Patentamt
European Patent Office
Office européen des brevets

(11) **EP 4 317 491 A1**

(12) **EUROPEAN PATENT APPLICATION**
published in accordance with Art. 153(4) EPC

(43) Date of publication:
**07.02.2024 Bulletin 2024/06**

(21) Application number: **22775468.6**

(22) Date of filing: **18.03.2022**

(51) International Patent Classification (IPC):
**C22C 9/00** (2006.01)      **C22C 30/02** (2006.01)
**G01R 1/06** (2006.01)

(52) Cooperative Patent Classification (CPC):
**C22C 9/00; C22C 30/02; G01R 1/06**

(86) International application number:
**PCT/JP2022/012690**

(87) International publication number:
**WO 2022/202681 (29.09.2022 Gazette 2022/39)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority:  26.03.2021   JP 2021053271
         10.02.2022   JP 2022019210

(71) Applicants:
• **Ishifuku Metal Industry Co., Ltd.**
  **Chiyoda-ku,**
  **Tokyo 101-0047 (JP)**
• **Yokowo Co., Ltd**
  **Tokyo 101-0041 (JP)**

(72) Inventors:
• **EGAWA, Yasunori**
  **Soka-shi, Saitama 340-0002 (JP)**
• **MATSUZAWA, Atsuo**
  **Soka-shi, Saitama 340-0002 (JP)**
• **HASEGAWA, Koichi**
  **Soka-shi, Saitama 340-0002 (JP)**
• **IMAI, Yosuke**
  **Soka-shi, Saitama 340-0002 (JP)**
• **SATO, Kenichi**
  **Tomioka-Shi, Gunma 370-2495 (JP)**

(74) Representative: **TBK**
  **Bavariaring 4-6**
  **80336 München (DE)**

(54)   **ALLOY MATERIAL FOR PROBE PINS**

(57)    Provided is a probe material (an alloy material for probe pins) that can suppress diffusion of components between solder in a circuit connecting portion of an inspection target and the probe material during probe inspection. The alloy material for probe pins consists of 15 mass% to 60 mass% of Pd, 3 mass% to 79.9 mass% of Cu, and 0.1 mass% to 75 mass% of Ni and/or Pt.

EP 4 317 491 A1

**Description**

Technical Field

The present invention relates to an alloy material for probe pins (hereinafter referred to as "probe material") for inspecting the electrical characteristics of an integrated circuit on a semiconductor wafer, a liquid crystal display device, or the like.

Background Art

For inspection of the electrical characteristics of an integrated circuit formed on a semiconductor wafer, a liquid crystal display device, or the like, a socket or a probe card in which a plurality of probes are incorporated has been used. This inspection is performed by bringing probe pins incorporated in the socket or the probe card into contact with an electrode, a terminal, or a conductive portion of the integrated circuit, the liquid crystal display device, or the like.

Such probe pins are required to have low contact resistance and hardness enough to withstand repeated contact. For example, a beryllium-copper alloy, tungsten, a tungsten alloy, a platinum alloy, or a palladium alloy is used as a probe material.

In US 1935897 A, there is a disclosure of a palladium alloy (hereinafter referred to as "AgPdCu alloy") composed of not less than 16% and not more than 50% copper, palladium ranging from about 35% to about 59%, and silver to the extent of not less than 4%.

Citation List

Patent Literature

[PTL 1] US 1935897 A

Summary of Invention

Technical Problem

The AgPdCu alloy, which has excellent plastic workability and is precipitation-hardened, has been used as the probe material because of its shape stability resulting from its hardness and low specific resistance characteristics. However, the following problem has been found when such probe material is used on a circuit connecting portion where solder (e.g., Sn-Bi-based solder) is used. During inspection, a probe pin and the solder are repeatedly brought into contact with each other, and an electrical current flows therebetween. As a result, a solder component such as Sn and a component of the probe material interdiffuse due to the resulting Joule heat or the like, and a tip end of the probe pin tends to be rapidly consumed. In such case, contact resistance varies suddenly or over time, resulting in the occurrence of an inspection defect. Accordingly, cleaning or exchange of a tip end portion of the probe pin to be brought into contact is required, and there has been a problem in that the operating rate of an inspection step is reduced.

In view of the foregoing, there is a strong demand for development of a probe material having solder resistance sufficient to suppress the diffusion of the solder component.

An object of the present invention is to provide a probe material that can suppress the diffusion of components between solder in a circuit connecting portion of an inspection target and the probe material during probe inspection.

Solution to Problem

The inventors of the present invention have discovered a probe material consisting of 15 mass% to 60 mass% of Pd, 3 mass% to 79.9 mass% of Cu, and 0.1 mass% to 75 mass% of Ni and/or Pt, and thus completed the present invention.

Advantageous Effects of Invention

According to the present invention, a probe material can be provided that suppresses diffusion of components between solder in a circuit connecting portion of an inspection target and the probe material itself during inspection.

Description of Embodiments

The present invention is directed to a probe material consisting of 15 mass% to 60 mass% of Pd, 3 mass% to 79.9 mass% of Cu, and 0.1 mass% to 75 mass% of Ni and/or Pt. When both Ni and Pt are included, the total content thereof is from 0.1 mass% to 75 mass%.

Pd has excellent corrosion resistance. However, when the content of Pd is less than 15 mass%, its corrosion resistance becomes insufficient. Meanwhile, when the content of Pd is more than 60 mass%, it is not suitable because diffusion of components between solder and the probe material cannot be sufficiently suppressed.

As another aspect, the content of Pd may be from 17 mass% to 55 mass%. In addition, in another aspect, the content of Pd may be from 20 mass% to 50 mass%.

Cu has low specific resistance, and in addition, when alloyed with Pd, it has the effect of enhancing hardness. Meanwhile, when Cu is added in a large amount, the corrosion resistance is reduced. Accordingly, when the content of Cu is less than 3 mass%, sufficient hardness is not obtained, and when the content of Cu is more than 79.9 mass%, the corrosion resistance is reduced.

As another aspect, the content of Cu may be from 5 mass% to 74 mass%.

When alloyed with Ni and/or Pt, the alloy exhibits improved solder resistance. According to experiments, when the content of Ni and/or Pt is less than 0.1 mass%, it is not suitable because diffusion of components between the solder and the probe material cannot be sufficiently suppressed. Furthermore, when the content of Ni and/or Pt is more than 75 mass%, it is not suitable because the specific resistance is increased.

As another aspect, the content of Ni and/or Pt may be from 0.3 mass% to 70 mass%. When both Ni and Pt are included, the total content thereof may be from 0.3 mass% to 70 mass%. In addition, as another aspect, the content of Ni and/or Pt may be from 0.5 mass% to 65 mass%. When both Ni and Pt are included, the total content thereof may be from 0.5 mass% to 65 mass%.

For the alloy of the present invention, it is critical to suppress a phenomenon in which a tip end of a probe pin is consumed due to diffusion of components between the solder and the probe material. The alloy of the present invention is not required to have hardness as high as that of the conventional AgPdCu alloy. The solder (e.g., Sn-Bi-based solder) with which the probe pin is brought into contact has relatively low hardness. Therefore, a hardness of 200 HV or more is sufficient for the probe material.

In the alloy of the present invention, it is presumed that diffusion of components between the solder and the probe material is suppressed for the following reason. Specifically, Ni and/or Pt added to the probe material forms a thin and dense intermetallic compound layer of, for example, Sn-Ni and/or Sn-Pt at an interface where the solder and the probe pin are brought into contact with each other. This intermetallic compound layer exhibits a preventing effect on the diffusion of components between the solder and the probe material, and thus suppresses easy consumption of the tip end of the probe pin.

Examples

Examples of the present invention are described. The compositions and respective characteristics of alloys of Examples and Comparative Examples are shown in Table 1.

First, elements Pd, Cu, Ni, and Pt were mixed so as to achieve the compositions shown in Table 1. The mixture was then melted in an argon atmosphere by an arc melting method to produce alloy ingots.

The alloy ingots were each repeatedly subjected to rolling and heat treatment to produce sheet materials having a target reduction ratio of 75%. The reduction ratio of the sheet materials was calculated using the formula: [(Initial Thickness before Rolling and Heat Treatment - Final Thickness after Rolling and Heat Treatment) / Initial Thickness before Rolling and Heat Treatment] × 100. Each of the resulting sheet materials was then used as a test piece for evaluation of hardness and solder resistance. In addition, other sheet materials were produced so as to have a reduction ratio of 90%. The reduction ratio of the additional sheet materials was calculated using the same formula. Each of the additional sheet materials was then used as a test piece for evaluation of specific resistance.

The test pieces of the alloys having been produced were each subjected to the following evaluations. The evaluation results are shown in Table 2.

The hardness at the center of each test piece's cross section was measured using a micro Vickers hardness tester under the conditions of a load of 200 gf and a holding time of 10 seconds.

The solder resistance was evaluated as described below. Sn-Bi-based solder was placed on each test piece of the alloy having been produced, and the solder was melted onto the test piece through heat treatment in a $N_2$ atmosphere under the conditions of 250°C and 1 hour. After the heat treatment, the test piece was embedded in a resin and a cross section thereof was exposed. At the interface between the solder and the test piece, Sn from the solder and Pd from the alloy interdiffused to form a layer where both Sn and Pd coexist. This layer was regarded as a diffusion layer. The interface between the solder and the test piece was then subjected to line analysis in a vertical direction using an EPMA, and the thickness of the diffusion layer was measured.

It was judged that, as the thickness of the diffusion layer having been measured was smaller, the solder resistance was higher. The evaluation was performed as follows: an alloy forming a diffusion layer having a thickness of less than 100 um was indicated by Symbol "oo"; an alloy forming a diffusion layer having a thickness of from 100 um to 200 um was indicated by Symbol "o"; an alloy forming a diffusion layer having a thickness of from 200 um to 500 um was indicated by Symbol "Δ"; and an alloy forming a diffusion layer having a thickness of more than 500 um was indicated by Symbol "×". The evaluation results are shown in Table 2. The case in which the thickness of the diffusion layer was 800 um or more was unambiguously described as "800 um" because the diffusion layer was formed in almost the entirety of the solder having been tested.

The electrical resistance of each test piece was measured at room temperature, and the specific resistance (electric resistivity) thereof was calculated according to Equation 1.

```
Equation 1: Specific Resistance = (Electrical Resistance

  × Cross-Sectional Area) / Measurement Length
```

Table 1

| No. | Composition (mass%) | | | | | |
|---|---|---|---|---|---|---|
| | Pd | Cu | Ni | Pt | Ag | In |
| Example 1 | 48 | 22 | 30 | 0 | 0 | 0 |
| Example 2 | 45 | 30 | 25 | 0 | 0 | 0 |
| Example 3 | 45 | 45 | 10 | 0 | 0 | 0 |
| Example 4 | 45 | 50 | 5 | 0 | 0 | 0 |
| Example 5 | 35 | 45 | 20 | 0 | 0 | 0 |
| Example 6 | 35 | 55 | 10 | 0 | 0 | 0 |
| Example 7 | 35 | 64 | 1 | 0 | 0 | 0 |
| Example 8 | 35 | 64.5 | 0.5 | 0 | 0 | 0 |
| Example 9 | 30 | 40 | 30 | 0 | 0 | 0 |
| Example 10 | 25 | 65 | 10 | 0 | 0 | 0 |
| Example 11 | 25 | 74 | 1 | 0 | 0 | 0 |
| Example 12 | 45 | 30 | 0 | 25 | 0 | 0 |
| Example 13 | 45 | 5 | 0 | 50 | 0 | 0 |
| Example 14 | 45 | 40 | 10 | 5 | 0 | 0 |
| Example 15 | 45 | 20 | 30 | 5 | 0 | 0 |
| Example 16 | 45 | 5 | 25 | 25 | 0 | 0 |
| Example 17 | 25 | 73 | 1 | 1 | 0 | 0 |
| Example 18 | 25 | 60 | 10 | 5 | 0 | 0 |
| Example 19 | 20 | 10 | 10 | 60 | 0 | 0 |
| Example 20 | 25 | 25 | 5 | 45 | 0 | 0 |
| Comparative Example 1 | 45 | 30 | 0 | 0 | 24.5 | 0.5 |
| Comparative Example 2 | 45 | 55 | 0 | 0 | 0 | 0 |
| Comparative Example 3 | 75 | 15 | 10 | 0 | 0 | 0 |

Table 2

| No. | Specific resistance μΩ·cm | Hardness HV | Thickness of diffusion layer μm | Evaluation of thickness of diffusion layer |
|---|---|---|---|---|
| Example 1 | 50 | 340 | 10 | ○○ |
| Example 2 | 60 | 300 | 10 | ○○ |
| Example 3 | 30 | 290 | 20 | ○○ |
| Example 4 | 20 | 280 | 20 | ○○ |
| Example 5 | 50 | 280 | 20 | ○○ |
| Example 6 | 20 | 270 | 20 | ○○ |
| Example 7 | 20 | 250 | 20 | ○○ |
| Example 8 | 20 | 240 | 70 | ○○ |
| Example 9 | 60 | 300 | 10 | ○○ |
| Example 10 | 20 | 240 | 20 | ○○ |
| Example 11 | 20 | 210 | 20 | ○○ |
| Example 12 | 70 | 280 | 190 | ○ |
| Example 13 | 50 | 250 | 80 | ○○ |
| Example 14 | 50 | 280 | 20 | ○○ |
| Example 15 | 50 | 340 | 10 | ○○ |
| Example 16 | 40 | 380 | 10 | ○○ |
| Example 17 | 20 | 210 | 60 | ○○ |
| Example 18 | 30 | 250 | 20 | ○○ |
| Example 19 | 60 | 390 | 10 | ○○ |
| Example 20 | 70 | 330 | 10 | ○○ |
| Comparative Example 1 | 20 | 350 | 600 | × |
| Comparative Example 2 | 20 | 270 | 800 | × |
| Comparative Example 3 | 40 | 290 | 800 | × |

It is found from the above-mentioned results that the alloys produced according to the present invention each have high solder resistance, and also have hardness and specific resistance required for a probe material. Consequently, according to the present invention, the material suitable as a probe material having solder resistance can be provided.

**Claims**

1. An alloy material for probe pins, consisting of:

15 mass% to 60 mass% of Pd;
3 mass% to 79.9 mass% of Cu; and
0.1 mass% to 75 mass% of Ni and/or Pt.

# EP 4 317 491 A1

**INTERNATIONAL SEARCH REPORT**

| International application No. |
|---|
| **PCT/JP2022/012690** |

## A. CLASSIFICATION OF SUBJECT MATTER

*C22C 9/00*(2006.01)i; *C22C 30/02*(2006.01)i; *G01R 1/06*(2006.01)i
FI:     C22C30/02; C22C9/00; G01R1/06 B

According to International Patent Classification (IPC) or to both national classification and IPC

## B. FIELDS SEARCHED

Minimum documentation searched (classification system followed by classification symbols)

C22C5/04; C22C9/00-9/10; C22C19/03-19/05; C22C30/02; G01R1/06-1/073

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
|---|---|---|
| A | JP 2004-93355 A (TOSHIBA CORP.) 25 March 2004 (2004-03-25) | 1 |
| A | WO 2014/049874 A1 (TOKURIKI HONTEN CO., LTD.) 03 April 2014 (2014-04-03) | 1 |
| A | JP 2017-25354 A (TOKURIKI HONTEN CO., LTD.) 02 February 2017 (2017-02-02) | 1 |
| A | JP 2017-145496 A (NHK SPRING CO., LTD.) 24 August 2017 (2017-08-24) | 1 |
| A | JP 2016-172887 A (SUMITOMO METAL MINING CO., LTD.) 29 September 2016 (2016-09-29) | 1 |

| ☐ Further documents are listed in the continuation of Box C. | ☑ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **22 April 2022** | **17 May 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2022/012690**

| Patent document cited in search report | | | Publication date (day/month/year) | Patent family member(s) | | | Publication date (day/month/year) |
|---|---|---|---|---|---|---|---|
| JP | 2004-93355 | A | 25 March 2004 | (Family: none) | | | |
| WO | 2014/049874 | A1 | 03 April 2014 | US | 2015/0197834 | A1 | |
| | | | | TW | 201422826 | A | |
| | | | | CN | 104685083 | A | |
| | | | | KR 10-2015-0056556 | | A | |
| JP | 2017-25354 | A | 02 February 2017 | (Family: none) | | | |
| JP | 2017-145496 | A | 24 August 2017 | (Family: none) | | | |
| JP | 2016-172887 | A | 29 September 2016 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 1935897 A